# EUROPÄISCHE PATENTANMELDUNG

(11) **EP 0 994 509 A2**
(43) Veröffentlichungstag der Anmeldung: **19.04.2000**
(21) Anmeldenummer: 99119529.8
(22) Anmeldetag: 01.10.1999
(51) Int. Cl.: H01L 25/16, H01L 31/0203, H01L 31/12, H01L 31/0232

(54) **Bauteil zur optischen Datenübertragung**

(30) Priorität: 05.10.1998 DE 19845703
(71) Anmelder: Vishay Semiconductor GmbH, 74072 Heilbronn (DE)
(72) Erfinder: Krieger, Jochen, 74847 Obrigheim (DE)
(74) Vertreter: Kolb, Georg

(57) **Zusammenfassung**

Bauteile zur optischen Datenübertragung, zum Beispiel Photomodule und Transceiver, nach dem Stand der Technik sind aufgrund ihres Aufbaus sehr anfällig gegen optische und elektromagnetische Störungen. Notwendige Schutzmaßnahmen verteuern die Bauteile merklich. Deshalb soll ein Bauteil angegeben werden, das auch ohne besondere Schutzmaßnahmen weitgehend störunanfällig ist.

Bauteil (13) zur optischen Datenübertragung, bei dem ein Gitterstreifen (1) mit Anschlussbeinchen (2) auf seiner Ober- und Unterseite jeweils eine Bestückungsfläche (3, 4) aufweist, wobei die oberseitige Bestückungsfläche (3) und die unterseitige Bestückungsfläche (4) nicht übereinander angeordnet sind und die Bestückungsfläche auf der Oberseite (3) zur Aufnahme wenigstens einer optoelektronischen Komponente (7) und die Bestückungsfläche auf der Unterseite (4) zur Aufnahme eines Integrierten Schaltkreises (5) dient.

Das erfindungsgemäße Bauteil zur gerichteten, optischen und leitungsungebundenen Datenübertragung findet seine Anwendung als Photomodul hauptsächlich in ferngesteuerten Audio- und Videogeräten der Unterhaltungselektronik oder als Transceiver in Geräten der Informationstechnik.

## Beschreibung

Die Erfindung betrifft ein Bauteil zur gerichteten, optischen und leitungsungebundenen Datenübertragung nach dem Oberbegriff des Patentanspruchs 1.

Für die gerichtete, optische und leitungsungebundene Datenübertragung wird überwiegend Infrarot-Strahlung verwendet, weshalb man häufig von IRDC (**I**nf**r**ared **D**ata **C**ommunication) spricht. IRDC wird in der Unterhaltungselektronik verwendet, um Fernseh- und Audiogeräte über eine Infrarotstrecke mittels einer Fernsteuerung ( 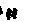 Telepilot") aus einer bestimmten Entfernung steuern zu können. Bei einer solchen Verbindung handelt es überwiegend um eine unidirektionale Datenübertragung von der Fernsteuerung zum Gerät, weshalb im zu steuernden Gerät lediglich ein optoelektronischer Empfänger (Detektor, Receiver) mit nachgeschaltetem Integriertem Schaltkreis zur Aufbereitung der elektrischen Datensignale, ein sogenanntes 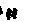 Photomodul", vorhanden sein muss.

In der informationstechnik hingegen, beispielsweise bei der drahtlosen Datenübertragung zwischen einem Personalcomputer und seiner Peripherie, handelt es sich meistens um eine bidirektionale Datenübertragung, so dass in jedem an der Datenübertragung teilnehmendem Gerät ein Sende- und Empfangsbauteil, ein sogenannter 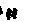 Transceiver" (aus **Trans**mitter und Re**ceiver**), eingebaut sein muss. Transceiver weisen demzufolge neben einem optoelektronischen Empfänger und einem Integrierten Schaltkreis zur Aufbereitung der elektrischen Datensignale noch einen optoelektronischen Sender (Transmitter) auf.

Bauteile zur optischen Datenübertragung nach dem Stand der Technik, wie sie beispielsweise aus der EP 0 566 921 bekannt sind, im wesentlichen also Photomodule und Transceiver, weisen den Nachteil auf, dass sie aufgrund ihres Aufbaus, insbesondere der Anordnung des Integrierten Schaltkreises, sehr anfällig gegen störende Einflüsse optischer und elektromagnetischer Art sind. Deshalb ist beispielsweise eine schwarze Verguss- oder Abdeckmasse als Schutz gegen optische Störungen und eine elektrisch leitende und geerdete, meist metallische Abdeckung als Schutz gegen optische und elektromagnetische Störungen notwendig. Derartige Schutzmaßnahmen verteuern solche Bauteile zur optischen Datenübertragung merklich.

Eine Anordnung zur zweiseitigen Chipmontage ist aus der EP 0 680 086 A bekannt. Durch die beidseitige Bestückung des 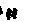 die pads" ist eine platzsparende Anordnung von zwei Halbleiterchips möglich. Die Anordnung ist jedoch für die Kombination eines optoelektronischen Halbleiterelements mit einem Integrierten Schaltkreis nicht geeignet, da die vom optoelektronischen Haibleiterelement empfangenen oder gesendeten optischen Datensignale im Integrierten Schaltkreis Störungen hervorrufen würden.

Es ist daher Aufgabe der Erfindung, ein Bauteil zur optischen Datenübertragung anzugeben, das die genannten Nachteile vermeidet und weit weniger störanfällig ist.

Diese Aufgabe wird durch die Merkmale des Anspruchs 1 gelöst, wonach ein Gitterstreifen mit Anschlussbeinchen auf seiner Ober- und Unterseite jeweils eine Bestückungsfläche aufweist, wobei die oberseitige Bestückungsfläche und die unterseitige Bestückungsfläche nicht übereinander angeordnet sind und wobei die Bestückungsfläche auf der Oberseite zur Aufnahme wenigstens einer optoelektronischen Komponente und die Bestückungsfläche auf der Unterseite zur Aufnahme eines Integrierten Schaltkreises dient.

Die Vorteile der Erfindung liegen darin, dass der Integrierte Schaltkreis zum einen durch den Gitterstreifen vor elektromagnetischen Strahlungen und zum andern durch den räumlichen Abstand zur optoelektronischen Komponente vor optischer Strahlung geschützt ist.

Vorteilhafte Weiterbildungen der Erfindung sind in den Unteransprüchen beschrieben.

Ein Ausführungsbeispiel der Erfindung ist nachstehend ausführlich erläutert und anhand der Figuren dargestellt.

Es zeigen
- Fig. 1:: eine perspektivische Darstellung eines noch nicht mit Mouldmasse vergossenen Bauteils ohne Linse,
- Fig. 2:: eine perspektivische Darstellung eines mit Mouldmasse vergossenen Bauteils mit einer Linse und
- Fig. 3:: eine perspektivische Darstellung eines Transceivers mit zwei Linsen.

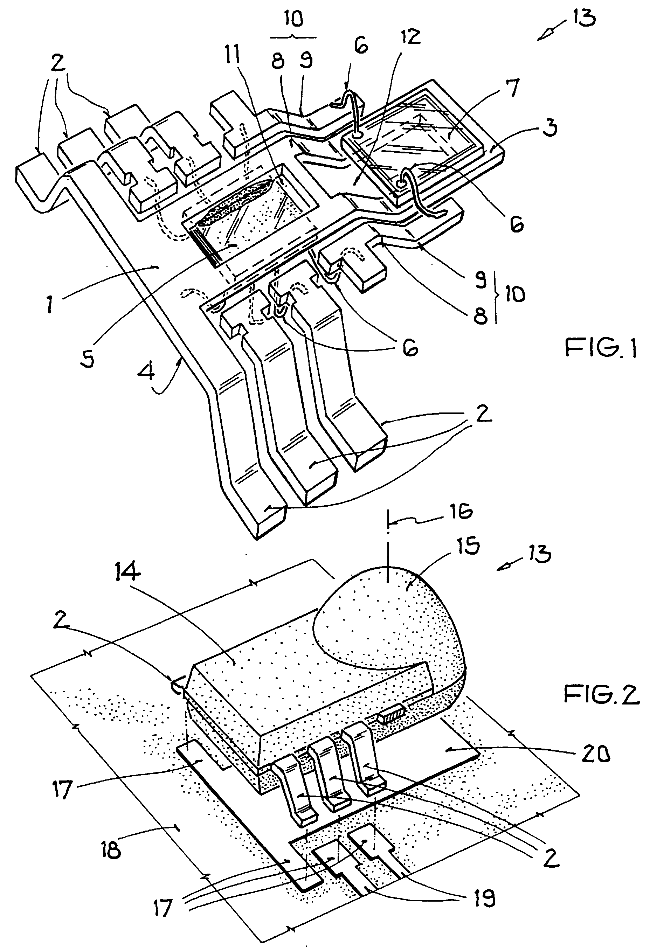

Die **Fig. 1** zeigt ein Photomodul **13** als optoelektronisches Bauteil zum Empfang optischer Datensignale, bestehend aus einem Gitterstreifen **1** mit Anschlussbeinchen **2**, der eine obere Bestückungsfläche **3** und eine untere Bestückungsfläche **4** aufweist. Auf der unteren Bestückungsfläche **4** ist ein Integrierter Schaltkreis **5** und auf der oberen Bestückungsfläche **3** ein optoelektronischer Empfänger (Detektor) **7** zum Empfang optischer Datensignale befestigt, vorzugsweise durch Kleben oder Chipbonden. Die jeweiligen elektrischen Anschlüsse des Integrierten Schaltkreises **5** und des Detektors **7** sind mittels Bonddrähten **6** mit den jeweils zugehörigen Anschlussbeinchen **2** verbunden. Der Gitterstreifen **1** ist aus einem bekannten Material, vorzugsweise einer Kupfer- oder Eisenlegierung, hergestellt. Die optischen Datensignale bestehen vorteilhaft aus infraroter Strahlung.

Zwischen dem oberseitig befestigten optoelektronischen Empfänger **7** und dem unterseitig befestigten Integrierten Schaltkreis **5** weist der Gitterstreifen **1** zwei entgegengesetzt verlaufende Biegestellen **8** und **9** auf, wodurch eine Abstufung **10** entsteht und sich die oberseitige Bestückungsfläche **3** unterhalb der unterseitigen Bestückungsfläche **4** befindet. Diese Maßnahme bringt den Vorteil mit sich, dass ein platzsparender Aufbau und demzufolge kleine Abmessungen des Photomoduls **13** erreicht werden. Um Material und Gewicht einzusparen, aber auch um eine ebene Auflagefläche für Integrierten Schaltkreis **5** und Detektor **7** zu erhalten, weisen die obere Bestückungsfläche **3** und die untere Bestückungsfläche **4** in ihrem Innenbereich jeweils eine Aussparung **11** bzw. **12** auf.

Aufgabe des Integrierten Schaltkreises **5** ist es, elektrische Datensignale aufzubereiten. Im Falle eines Photomoduls bedeutet das, die vom Detektor **7** kommenden elektrischen Signale von überlagerten Störsignalen zu befreien und das verbleibende Nutzsignal verstärkt und gegebenenfalls dekodiert an den Anschlussbeinchen **2** nachgeordneten Schaltungs- und Auswerteeinheiten zur Verfügung zu stellen. Im Falle eines Transceivers müssen im Integrierten Schaltkreis **5** zusätzlich die von vorgeschalteten Schaltungseinheiten kommenden elektrischen Datensignale den elektrischen Werten des optoelektronischen Transmitters angepasst und gegebenenfalls kodiert werden, so dass der Transmitter in der Lage ist, optische Datensignale zu bilden und diese über eine lnfrarotstrecke an einen Empfänger zu senden. Zur Abschirmung des Integrierten Schaltkreises **5** gegen elektromagnetische Störungen reichen die übrigen Metallteile des Gitterstreifens **1** aus, insbesondere dann, wenn sie geerdet sind.

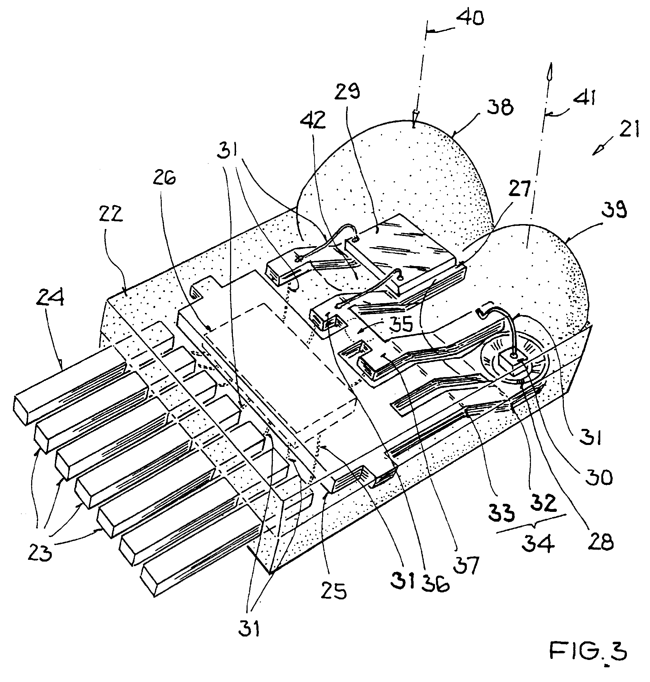

Die **Fig. 2** zeigt das fertig montierte Bauteil zur optischen Datenübertragung **13**, wobei es sich sowohl um ein Photomodul als auch um einen Transceiver handeln kann. Gitterstreifen **1** (nicht sichtbar), Anschlussbeinchen **2** und Integrierter Schaltkreis **5** (nicht sichtbar) sind mit einer vorteilhaft weissen Vergussmasse **14** ummantelt, um Umwelteinflüsse fernzuhalten. Auf lichtdämmende schwarze Verguss- oder Abdeckmasse, insbesondere für den Integrierten Schaltkreis **5**, kann verzichtet werden, da aufgrund der Anordnung der Integrierte Schaltkreis **5** nicht von einfallendem Licht gestört wird. Daraus ergibt sich auch der Vorteil, dass benötigtes Fertigungsequipment weniger verschmutzt wird.

Zur Fokussierung der zu empfangenden bzw. zur Bündelung der zu sendenden IR-Strahlen oder Signale ist über dem Empfänger **7** (nicht sichtbar) bzw. über dem Sender und Empfänger **7** als optisches System eine konvexe Linse **15** mit einer optischen Achse **16** angeordnet, wobei die optische Achse **16** in der Regel senkrecht auf dem Empfängerelement **7** bzw. dem Sende- und Empfängerelement **7** steht. Die halbkugelförmige Linse **15** besteht aus einer für IR-Strahlen durchlässigen Vergussmasse, in die vorteilhaft verschiedene Farbstoffe gemischt sind, um störende Strahlung bestimmter Wellenlängen, zum Beispiel aus dem Sonnenlicht, auszufiltern. Die Anschlussbeinchen **2** sind auf Kontaktflächen **17** einer Leiterplatte **18** aufgelötet, die mit Leitbahnen **19** verbunden sind. Zur Abschirmung elektromagnetischer Störungen ist es besonders vorteilhaft, wenn auf der Leiterplatte **18** unter dem Bauteil **13** eine elektrisch leitende und geerdete Schicht **20**, vorzugsweise aus Kupfer, auflaminiert ist.

**Fig. 3** zeigt als Bauteil einen Transceiver **21** zum Senden und Empfangen optischer Datensignale mit einem Gehäuse **22** aus vorzugsweise transparenter Kunststoffmasse, Anschlussbeinchen **23** und einem Gitterstreifen **24**, auf dessen Unterseite auf einer Bestückungsfläche **25** ein Integrierter Schaltkreis **26** zur Aufbereitung der Datensignale angeordnet ist. Auf seiner Oberseite weist der Gitterstreifen **24** zwei Bestückungsflächen **27** und **28** auf. Auf der Bestückungsfläche **27** ist ein optoelektronischer Detektor **29** zum Empfangen optischer Datensignale und auf der Bestückungsfläche **28**, die sich auf der gleichen Ebene wie die Bestückungsfläche **27** befindet, ein optoelektronischer Emitter **30** zum Senden optischer Datensignale angeordnet. Unter dem Detektor **29** weist der Gitterstreifen **24** eine Aussparung **42** auf. Bonddrähte **31** stellen die elektrische Verbindung zwischen den Anschlussbeinchen **23** und dem Gitterstreifen **24** einerseits und zwischen den Komponenten **26**, **29** und **30** andererseits her.

Wie beim Ausführungsbeispiel gemäß Fig. 1 weist der Gitterstreifen **24** zwei entgegengesetzt verlaufende Biegestellen **32** und **33** auf, wodurch eine Abstufung **34** entsteht und sich die oberseitigen Bestückungsflächen **27** und **28** unterhalb der unterseitigen Bestückungsfläche **25** befinden. Weiterhin weist der Gitterstreifen **24** ein sogenanntes Trennkreuz **35** auf, das Teile **36** und **37** des Gitterstreifens **24** zusammenhält und das während der Montage entfernt wird. Über dem Detektor **29** bzw. dem Emitter **30** ist jeweils ein optisches System in Form einer Linse **38** bzw. **39** angeordnet, um die zu empfangenen optischen Datensignale auf den Detektor **29** zu fokussieren bzw. die vom Emitter **30** gesendeten optischen Datensignale zu bündeln. Jede Linse **38** bzw. **39** weist eine optische Achse **40** bzw. **41** auf.

Detektor **29** und Emitter **30** können auch, in Abweichung zum gezeigten Ausführungsbeispiel der Fig. 3, übereinander in zwei parallelen Ebenen angeordnet sein. Hierzu wird vorzugsweise das kleinere Emitterchip **30** beispielsweise mittels leitfähigem oder nicht leitfähigem Kleber oder durch Chipbonden auf dem größeren Detektorchip **29** befestigt. Werden Detektor **29** und Emitter **30** übereinander in zwei parallelen Ebenen angeordnet, genügt zur Verstärkung bzw. Fokussierung der optischen Datensignale nur ein optisches System. Einem Fachmann ist es ohne weiteres möglich, die hierzu notwendige Änderung der Geometrie des Gitterstreifens **24** und der Anschlussbeinchen **23** vorzunehmen.

Das erfindungsgemäße Bauteil zur gerichteten, optischen und leitungsungebundenen Datenübertragung findet seine Anwendung als Photomodul hauptsächlich in ferngesteuerten Audio- und Videogeräten der Unterhaltungselektronik oder als Transceiver in Geräten der Informationstechnik.

## Patentansprüche

1. Bauteil (13; 21) zur gerichteten, optischen und leitungsungebundenen Datenübertragung mittels elektrischer und optischer Datensignale, **gekennzeichnet durch folgende Merkmale:**
a) ein Gitterstreifen (1; 24) mit Anschlussbeinchen (2; 23) weist auf seiner Ober- und Unterseite jeweils wenigstens eine Bestückungsfläche (3, 4; 25, 26, 27) auf,
b) die oberseitigen Bestückungsflächen (3; 27, 28) und die unterseitige Bestückungsfläche (4; 25) sind nicht übereinander angeordnet,
c) die oberseitigen Bestückungsflächen (3; 27, 28) dienen zur Aufnahme wenigstens einer optoelektronischen Komponente (7; 29, 30) und
d) die unterseitige Bestückungsfläche (4; 25) dient zur Aufnahme eines Integrierten Schaltkreises (5; 26).

2. Bauteil (13; 21) nach Anspruch 1, **dadurch gekennzeichnet,** dass der Gitterstreifen (1; 24) zwischen den oberseitig befestigten optoelektronischen Komponenten (7; 29, 30) und dem unterseitig befestigten Integrierten Schaltkreis (5; 26) zwei entgegengesetzte Biegestellen (8, 9; 32, 33) aufweist, wodurch eine Abstufung (10; 34) entsteht und sich die oberseitigen Bestückungsflächen (3; 27, 28) unterhalb der unterseitigen Bestückungsfläche (4; 25) befindet.

3. Bauteil (13; 21) nach Anspruch 1 oder 2, **dadurch gekennzeichnet,** dass die oberseitigen Bestückungsflächen (3; 26, 27) und die unterseitige Bestückungsfläche (4; 25) in ihrem Innenbereich jeweils eine Aussparung (11, 12; 42) aufweisen.

4. Bauteil (13; 21) nach Anspruch 1 bis 3, **dadurch gekennzeichnet,** dass über den optoelektronischen Komponenten (7; 29, 30) zur Fokussierung bzw. Bündelung optischer Signale jeweils ein optisches System (15; 38, 39) mit einer optischen Achse (16; 40, 41) angeordnet ist.

5. Bauteil (13; 21) nach den Ansprüchen 1 bis 4, **dadurch gekennzeichnet,** dass es sich bei einer optoelektronischen Komponente (7; 29) um einen Detektor handelt.

6. Bauteil (13; 21) nach den Ansprüchen 1 bis 4, **dadurch gekennzeichnet,** dass es sich bei einer anderen optoelektronischen Komponente (30) um einen Emitter handelt.

7. Bauteil (13; 21) nach den Ansprüchen 1 bis 6, **dadurch gekennzeichnet,** dass Emitter (30) und Detektor (7; 29) in einer Ebene nebeneinander angeordnet sind.

8. Bauteil (13; 21) nach den Ansprüchen 1 bis 6, **dadurch gekennzeichnet,** dass Emitter (30) und Detektor (7; 29) in zwei parallelen Ebenen übereinander angeordnet sind.

9. Bauteil (13; 21) nach Anspruch 8, **dadurch gekennzeichnet,** dass der Emitter (30) auf dem Detektor (7; 29) angeordnet ist.

10. Bauteil (13; 21) nach einem der Ansprüche 1 bis 9, **dadurch gekennzeichnet,** dass der Gitterstreifen (1; 24) und der Integrierte Schaltkreis (5; 26) von einer transparenten Vergussmasse (14; 22) umschlossen sind.

11. Bauteil (13; 21) nach einem der vorangehenden Ansprüche, **dadurch gekennzeichnet,** dass zur optischen Datenübertragung infrarote Strahlung verwendet wird.
